# EUROPEAN PATENT APPLICATION

(11) **EP 4 761 101 A1**
(43) Date of publication of application: **17.06.2026**
(21) Application number: 25215926.4
(22) Date of filing: 14.11.2025
(51) Int. Cl.: H02P 29/028, H02P 27/08

(54) **MULTIPLEXING CONTROL APPARATUS FOR MOTOR**

(30) Priority: 12.12.2024 JP 2024217499
(71) Applicant: NABTESCO CORPORATION, Chiyoda-ku Tokyo 102-0093 (JP)
(72) Inventor: Horikawa, Shogo, Chiyoda-ku, Tokyo, 102-0093 (JP); Jinno, Takayuki, Chiyoda-ku, Tokyo, 102-0093 (JP); Ogawa, Takashi, Chiyoda-ku, Tokyo, 102-0093 (JP); Ota, Yuya, Chiyoda-ku, Tokyo, 102-0093 (JP); Fukui, Atsushi, Chiyoda-ku, Tokyo, 102-0093 (JP)
(74) Representative: Grünecker Patent- und Rechtsanwälte PartG mbB

(57) **Abstract**

A multiplexing control apparatus (210) includes: three controllers (C1-C3) that output a digital voltage signal including two-phase voltage command values for a motor (300) in an orthogonal coordinate (fixed coordinate) system (α, β); and a signal control unit that receives the digital voltage signal output from at least two of the three controllers (C1-C3), selects, based on a predetermined priority order, the digital voltage signal output by the controller (C), of the controllers (C) outputting the digital signal input to the signal control unit (211), that does not malfunction and generates and outputs a PWM signal based on the digital voltage signal selected.

## Description

### BACKGROUND

The present invention relates to a multiplexing control technology for a motor.

The multiplexing control apparatus disclosed in patent literature 1 may be used to control various parts of aircraft such as a hydraulic actuator. The multiplexing control apparatus disclosed in patent literature 1 is equipped with three controllers. The same input signal is input to the three controllers, and the three controllers output the same output signal. The output signals of the three controllers are input to a majority circuit. The majority circuit determines an ultimate output by a majority decision on the inputs from the three controllers. In this way, the multiplexing controller disclosed in patent document 1 constitutes a multiplex redundancy processing circuit capable of obtaining a correct processing result as output data even if a failure occurs in some systems.

### [Patent Literature 1] JPH1-98034

It is desired to use a multiplexing control apparatus such as that of patent literature 1 to control the motor that drives the rotary blade part of a flight vehicle such as an electric vertical take-off and landing aircraft (hereinafter referred to as an eVTOL).

In this background, a general purpose of the present invention is to provide a technology of applying a multiplexing control apparatus to motor control.

A multiplexing control apparatus according to an embodiment of the present invention includes: three controllers that output a digital voltage signal including two-phase voltage command values for a motor in an orthogonal coordinate system; and a signal control unit that receives the digital voltage signal output from at least two of the three controllers, selects, based on a predetermined priority order, the digital voltage signal output by the controller, of the controllers outputting the digital signal input to the signal control unit, that does not malfunction and generates and outputs a PWM signal based on the digital voltage signal selected.

Optional combinations of the aforementioned constituting elements, and implementations of the invention in the form of methods, apparatuses, systems, recording mediums, and computer programs may also be practiced as additional modes of the present invention.
Fig. 1 is a top view schematically showing eVTOL1 of the embodiment.
Fig. 2 shows a schematic configuration of the motor control apparatus of the embodiment.
Fig. 3 shows a schematic configuration of the first controller of the embodiment.
Fig. 4 shows a schematic configuration of the signal control unit 211 of the embodiment.
Fig. 5 shows the status of the multiplexing control apparatus for each case.

The invention will now be described by reference to the preferred embodiments. This does not intend to limit the scope of the present invention, but to exemplify the invention.

### Embodiment

A description will now be given of an embodiment of a multiplexing control apparatus applied to flight vehicles such as eVTOL with reference to the drawing.

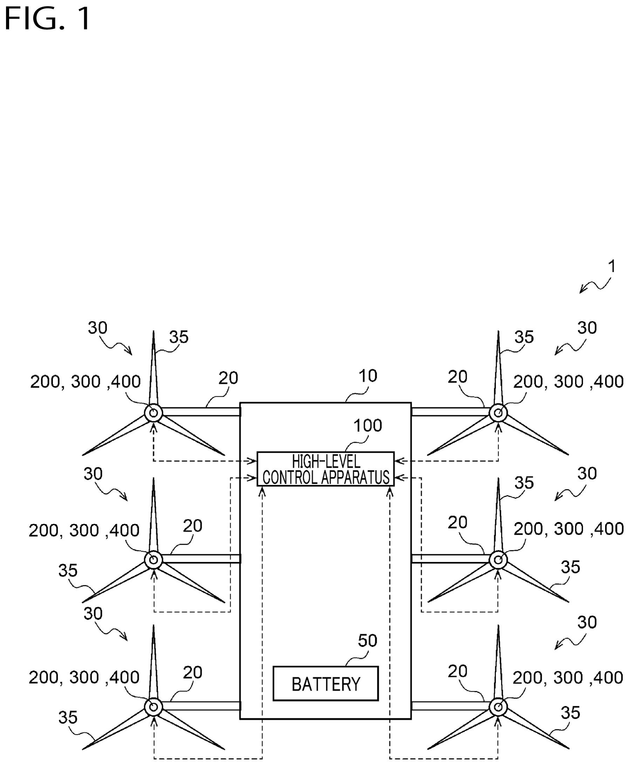

Fig. 1 is a top view schematically showing eVTOL1 of the embodiment. The eVTOL1 of the embodiment is configured as an unmanned aerial vehicle capable of taking off and landing in a vertical direction. eVTOL1 is equipped with a main unit 10 that makes up the fuselage part of the eVTOL 1, six arms 20, and six rotary blade parts 30. Each arm 20 supports the rotary blade part 30 provided in the arm. Each of the six rotary blade parts 30 is located at the end of the arm 20. Each rotary blade part 30 has three blades 35 arranged at equiangular intervals from each other. The eVTOL 1 of the embodiment is an example of a flight vehicle.

Each rotary blade part 30 includes a motor control apparatus 200, a motor 300, and a rotation detection sensor 400. The motor 300 is powered by a battery 50 and is driven into rotation. The motor 300 is, for example, a three-phase brushless motor. The motor control apparatus 200 controls the driving of the motor 300 based on a speed command from a high-level control apparatus 100. The rotation detection sensor 400 detects the rotation speed of the rotary blade part 30. The rotation detection sensor 400 of the embodiment detects the rotation speed of the rotor (not shown) of the motor 300 as the rotation speed of the rotary blade part 30, but the embodiment is not limited to. For example, the rotation speed of the blade 35 of the rotary blade part 30 may be detected. The result of detection by the rotation detection sensor 400 is output to the high-level control apparatus 100.

The main unit 10 houses the battery 50 and the high-level control apparatus 100. The battery 50 supplies power to the high-level control apparatus 100 as well as the motor control apparatus 200, the motor 300, the rotation detection sensor 400 provided in each rotary blade part 30, etc. The battery 50 is a rechargeable battery such as a lithium-ion battery that can be charged and discharged repeatedly.

The high-level control apparatus 100 performs various processes in the eVTOL1. The high-level control apparatus 100 is configured to communicate with the motor control apparatus 200 provided in each rotary blade part 30. The high-level control apparatus 100 outputs, to the motor control apparatus 200, a speed command for controlling the rotation speed of the rotary blade part 30 by controlling the motor 300. The speed command of the embodiment includes a command value for the rotation speed of the rotary blade part 30 (hereinafter referred to as a speed command value). The high-level control apparatus 100 generates, for example, the speed command value in the speed command in response to a user input via a user controller (not shown) for user manipulation of the eVTOL1.

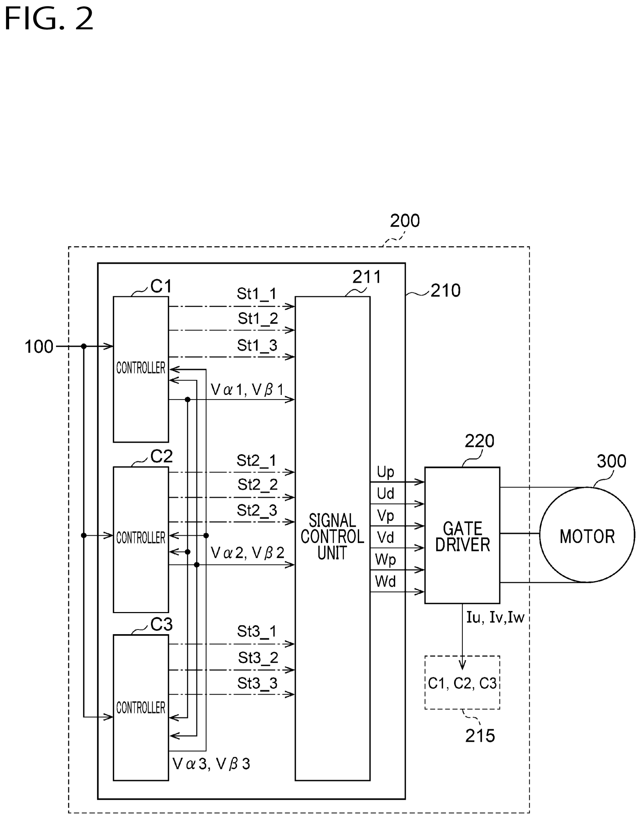

Fig. 2 shows a schematic configuration of the motor control apparatus 200 of the embodiment. As shown in Fig. 2, the motor control apparatus 200 is equipped with a multiplexing control apparatus 210 and a gate driver 220.

The multiplexing control apparatus 210 is equipped with first-third controllers C1-C3 and a signal control unit 211. The first-third controllers C1-C3 have basically the same configuration unless otherwise specified. In this specification, the controller may be generically referred to as a controller C in the case any of the first-third controllers C1-C3 is described in an unspecified manner.

The first controller C1 generates a voltage signal having a digital value (hereinafter, referred to as a digital voltage signal) and indicating two-phase voltage command values Vα1 and Vβ1 for the motor 300 in the orthogonal coordinate (fixed-coordinate) system (α, β), based on the speed command from the high-level control apparatus 100. The second controller C2 generates a digital voltage signal indicating two-phase voltage command values Vα2 and Vβ2 for the motor 300, based on the speed command from the high-level control apparatus 100. The third controller C3 generates a digital voltage signal indicating two-phase voltage command values Vα3 and Vβ3 for the motor 300, based on the speed command from the high-level control apparatus 100.

Further, the first controller C1 outputs status signals St1_1, St1_2, St1_3 to the signal control unit 211. The second controller C2 outputs status signals St2_1, St2_2, St2_3 to the signal control unit 211. The third controller C3 outputs status signals St3_1, St3_2, St3_3 to the signal control unit 211. Hereinafter, the status signal may be generically referred to as a status signal St in the case any of the status signals St1_1, St1_2, St1_3, St2_1, St2_2, St2_3, St3_1, St3_2, St3_3 is described in an unspecified manner. The status signal St will be described later.

The gate driver 220 has a U-phase arm, a V-phase arm, and a W-phase arm each being comprised of two switching elements (not shown) connected in series. The coil of the corresponding phase in the motor 300 is connected between the two switching elements of the U, V, W-phase arms of the gate driver 220. The gate driver 220 generates currents Iu, IV and Iw of the U phase, the V phase and the W phase by a known method, based on PWM signals Up and Ud, Vp and Vd, and Wp and Wd output from a PWM output unit 75 described later, and outputs Iu, IV and Iw to the motor 300 via the U-phase arm, the V-phase arm and the W-phase arm. The motor 300 is controlled by the U, V and W-phase currents Iu, IV and Iw of the gate driver 220. The switching element used in the gate driver 220 of the embodiment is IGBT, but the embodiment is not limited to. For example, FET may be used.

A detection unit 215 is connected to the gate driver 220. The detection unit 215 detects the three-phase currents Iu, IV, and Iw output from the gate driver 220 and outputs the currents to the first-third controllers C1-C3.

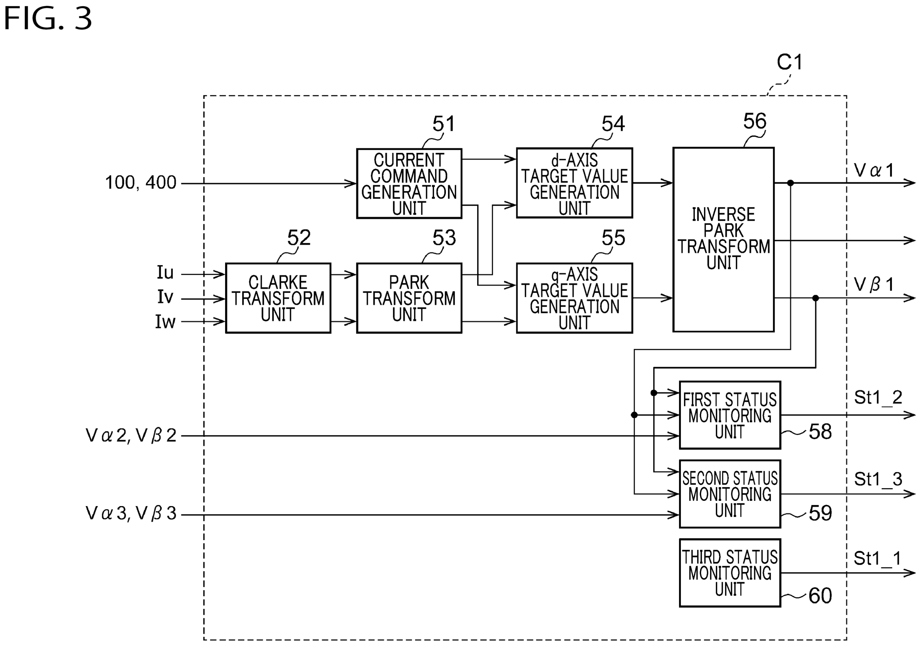

Fig. 3 shows a schematic configuration of the first controller C1 of the embodiment. The first controller C1 includes a current command generation unit 51, a Clarke transform unit 52, a Park transform unit 53, a d-axis target value generation unit 54, a q-axis target value generation unit 55, an inverse Park transform unit 56, and first-third status monitoring units 58-60.

The current command generation unit 51 generates a d-axis current command value and a q-axis current command value to adapt to the speed command from the high-level control apparatus 100, based on a difference between the speed command input from the high-level control apparatus 100 and the rotation speed detected by a rotation detection sensor 33. The current command generation unit 51 outputs the d-axis current command value to the d-axis target value generation unit 54 and outputs the q-axis current command value to the q-axis target value generation unit 55.

The Clarke transform unit 52 calculates two-phase current values Iα, Iβ in the orthogonal coordinate (fixed coordinate) system (α, β) by subjecting the three-phase currents Iu, Iv, Iw measured by the detection unit 215 to Clarke transform and outputs the calculated current values to the Park transform unit 53. The Park transform unit 53 calculates a q-axis detection value Iq and a d-axis detection value Id in the rotating coordinates from the two-phase currents Iα, Iβ in the fixed coordinate system by subjecting the currents Iα, Iβ to Park transform and outputs the detection values to the d-axis target value generation unit 54 and the q-axis target value generation unit 55.

The d-axis target value generation unit 54 sets a d-axis current target value based on the d-axis current command value output from the current command generation unit 51, the rotation speed output from the rotation detection sensor 33, and the d-axis detection value Id output from the Park transform unit 53. Further, the d-axis target value generation unit 54 computes the d-axis voltage target value at each predetermined period based on the d-axis current target value. For example, the d-axis target value generation unit 54 performs current feedback control such as proportional integral control (PI control) on the current deviation between the d-axis detection value Id and the d-axis current target value. As a result, the d-axis voltage target value is computed to bring the d-axis detection value Id closer to the d-axis current target value and is output to the inverse Park transform unit 56. The q-axis target value generation unit 55 similarly sets a q-axis current target value based on the q-axis current command value and the q-axis detection value Iq output from the Park transform unit 53, computes the q-axis voltage target value, and outputs the q-axis voltage target value thus computed to the inverse Park transform unit 56.

The inverse Park transform unit 56 calculates the two-phase voltage command values Vα1, Vβ1 in the fixed coordinate system from the rotating coordinates, by subjecting the d-axis voltage target value and the q-axis voltage target value to inverse Park transform and outputs Vα1, Vβ1 to the second controller C2, the third controller C3, and the signal control unit 211 in the form of a digital voltage signal.

The second controller C2, like the first controller, calculates the voltage command values Vα2, Vβ2 and outputs Vα2, Vβ2 in the form of a digital voltage signal to the first controller C1, the third controller C3, and the signal control unit 211. The third controller C3, like the first controller, calculates the voltage command values Vα3, Vβ3 and outputs Vα3 and Vβ3 in the form of a digital voltage signal to the first controller C1 and the second controller C2. Meanwhile, the third controller C3 of the embodiment does not output these signals to the signal control unit 211.

The first status monitoring unit 58 receives the voltage command values Vα1, Vβ1 included in the two-phase digital voltage signal generated by the inverse Park transform unit 56 and the voltage command values Vα2, Vβ2 included in the two-phase digital voltage signal output from the second controller C2. The first status monitoring unit 58 compares a difference between the average value of the voltage command values Vα1, Vβ1 and the average value of the voltage command values Vα2, Vβ2 with a predetermined threshold value. The first status monitoring unit 58 determines that the second controller C2 is not malfunctioning when an error between this difference and the predetermined threshold value is smaller than a predetermined further threshold value and outputs the value of 1 to the signal control unit 211 as a status signal St1_2. The first status monitoring unit 58 determines that the second controller C2 malfunctions when the error between the difference and the predetermined threshold value is equal to or larger than the further threshold value and outputs the value of 0 to the signal control unit 211 as the status signal St1_2. When the second controller C2 malfunctions and abnormal voltage command values Vα2, Vβ2 are output, for example, the value of 0 is output as the status signal St1_2.

The second status monitoring unit 59 receives the voltage command values Vα1, Vβ1 included in the two-phase digital voltage signal generated by the inverse Park transform unit 56 and the voltage command values Vα3, Vβ3 included in the two-phase digital voltage signal output from the third controller C3. The second status monitoring unit 59 compares a difference between the average value of the voltage command values Vα1, Vβ1 and the average value of the voltage command values Vα3, Vβ3 with a predetermined threshold value. The first status monitoring unit 58 determines that the third controller C3 is not malfunctioning when an error between this difference and the predetermined threshold value is smaller than a predetermined further threshold and outputs the value of 1 to the signal control unit 211 as the status signal St1_3. The first status monitoring unit 58 determines that the third controller C3 malfunctions when the error between the difference and the predetermined threshold value is equal to or greater than the further threshold value and outputs the value of 0 to the signal control unit 211 as the status signal St1_3. When the third controller C3 malfunctions and abnormal voltage command values Vα3, Vβ3 are output, for example, the value of 0 is output as the status signal St1_3.

The third status monitoring unit 60 outputs a status signal St1_1 based on whether an external malfunction occurs. An external malfunction refers to a malfunction in the motor control apparatus 200 in a part other than the multiplexing control apparatus 210 (gate driver 220, etc.). An external malfunction is detected by using a publicly known external malfunction detection apparatus adapted to the motor control apparatus 200. The third status monitoring unit 60 outputs the value of 1 as the status signal St1_1 to the signal control unit 211 when no external malfunction occurs. The third status monitoring unit 60 outputs the value of 0 as the status signal St1_1 to the signal control unit 211 when an external malfunction occurs.

The second controller C2, like the first controller C1, similarly outputs the status signals St2_1, St2_2, St2_3. For example, the first status monitoring unit 58 of the second controller C2 determines whether the first controller C1 malfunctions based on the voltage command values Vα2, Vβ2 included in the two-phase digital voltage signal generated by the inverse Park transform unit 56 and the voltage command values Vα1, Vβ1 included in the two-phase digital voltage signal output from the first controller C1 and outputs the determination to the signal control unit 211 in the form of the status signal St2_1 having the value of 0 or 1. Further, the second status monitoring unit 59 of the second controller C2, for example, determines whether the third controller C3 malfunctions based on the voltage command values Vα2, Vβ2 included in the two-phase digital voltage signal generated by the inverse Park transform unit 56 and the voltage command values Vα3, Vβ3 included in the two-phase digital voltage signal output from the third controller C3 and outputs the determination to the signal control unit 211 in the form of the status signal St2_3 having the value of 0 or 1. Further, the third status monitoring unit 60 of the second controller C2, for example, outputs the status signal St2_2 having the value of 0 or 1 to the signal control unit 211 depending on whether an external malfunction occurs.

The third controller C3, like the first controller C1, similarly outputs the status signals St3_1, St3_2, St3_3. For example, the first status monitoring unit 58 of the third controller C3 determines whether the first controller C1 malfunctions based on the voltage command values Vα3, Vβ3 included in the two-phase digital voltage signal generated by the inverse Park transform unit 56 and the voltage command values Vα1, Vβ1 included in the two-phase digital voltage signal output from the first controller C1 and outputs the determination to the signal control unit 211 in the form of the status signal St3_1 having the value of 0 or 1. Further, the second status monitoring unit 59 of the third controller C3, for example, determines whether the second controller C2 malfunctions based on the voltage command values Vα3, Vβ3 included in the two-phase digital voltage signal generated by the inverse Park transform unit 56 and the voltage command values Vα2, Vβ2 included in the two-phase digital voltage signal output from the second controller C2 and outputs the determination to the signal control unit 211 in the form of the status signal St3_2 having the value of 0 or 1. Further, the third status monitoring unit 60 of the third controller C3, for example, outputs the status signal St3_3 having the value of 0 or 1 to the signal control unit 211 depending on whether an external malfunction occurs.

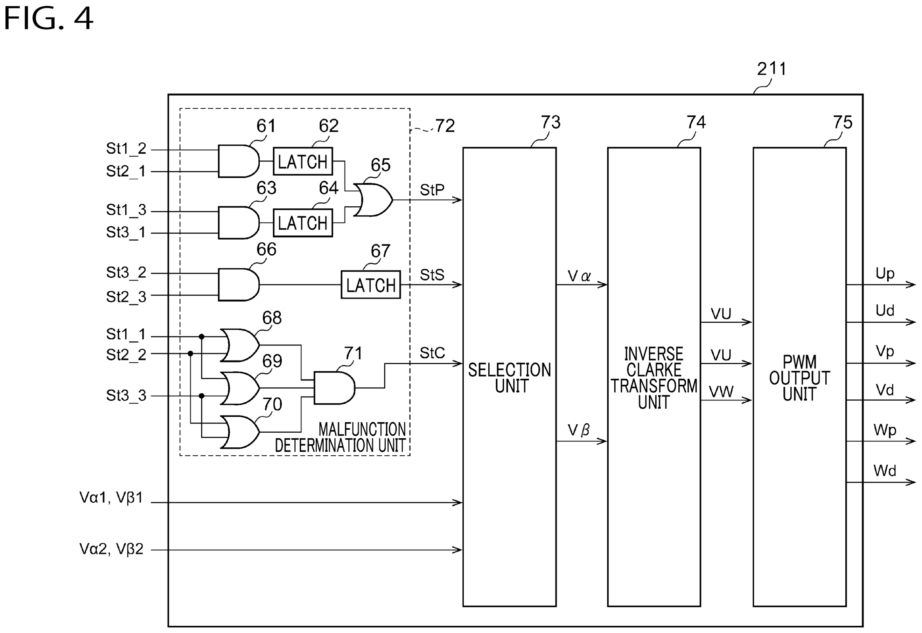

Fig. 4 shows a schematic configuration of the signal control unit 211 of the embodiment. The signal control unit 211 includes a malfunction determination unit 72, a selection unit 73, an inverse Clarke transform unit 74, and a PWM output unit 75. The malfunction determination unit 72 determines whether a malfunction occurs in the first-third controllers C1-C3 based on each status signal St output from the first-third controllers C1-C3. The malfunction determination unit 72 also determines whether an external malfunction occurs. The malfunction determination unit 72 includes first-fourth AND circuits 61, 63, 66, 71, first-fourth OR circuits 65, 68-70, and first-third latch circuits 62, 64, 67.

The first AND circuit 61 receives the status signals St1_2 and St2_1. The first AND circuit 61 outputs the value of 0 to the first latch circuit 62 when one of the input status signals St1_2 and St2_1 has the value of 0 (i.e., when the second controller C2 is determined to malfunction by the first controller C1, or the first controller C1 is determined to malfunction by the second controller C2). Meanwhile, the first AND circuit 61 outputs the value of 1 to the first latch circuit 62 when both the input status signals St1_2 and the St2_1 have the value of 1 (i.e., when the second controller C2 is not determined to malfunction by the first controller C1, and the first controller C1 is not determined to malfunction by the second controller C2).

The first latch circuit 62 receives the output signal of the first AND circuit 61. The first latch circuit 62 outputs an output signal having the value of 1 to the first OR circuit 65 when the value of the output signal of the first AND circuit 61 is 1. Meanwhile, the first latch circuit 62 outputs an output signal having the value of 0 to the first OR circuit 65 and subsequently maintains the output signal of the first latch circuit 62 at the value of 0, when the value of the output signal of the first AND circuit 61 is 0.

The second AND circuit 63 receives the status signals St1_3 and St3_1. The second AND circuit 63 outputs the value of 0 to the second latch circuit 64 when one of the input status signals St1_3 and St3_1 has the value of 0 (i.e., when the third controller C3 is determined to malfunction by the first controller C1, or the first controller C1 is determined to malfunction by the third controller C3). Meanwhile, the second AND circuit 63 outputs the value of 1 to the second latch circuit 64 when both the input status signals St1_3 and St3_1 have the value of 1 (i.e., when the third controller C3 is not determined to malfunction by the first controller C1, and the first controller C1 is not determined to malfunction by the third controller C3).

The second latch circuit 64 receives the output signal of the second AND circuit 63. The second latch circuit 64 outputs an output signal having the value of 1 to the first OR circuit 65 when the value of the output signal of the second AND circuit 63 is 1. Meanwhile, the second latch circuit 64 outputs an output signal having the value of 0 to the first OR circuit 65 and subsequently maintains the output signal of the second latch circuit 64 at the value of 0 when the value of the output signal of the second AND circuit 63 is 0.

The first OR circuit 65 receives each output signal of the first and second latch circuits 62, 64. The first OR circuit 65 outputs the value of 0 to the selection unit 73 when both the output signals input thereto have the value of 0 (i.e., when the first controller C1 is determined to malfunction either by the second controller C2 or the third controller C3, or when either the second controller C2 or the third controller C3 is determined to malfunction by the first controller C1). Meanwhile, the first OR circuit 65 outputs the value of 1 to the selection unit 73 when at least one of the output signals input thereto has the value of 1 (i.e., when the first controller C1 is not determined to malfunction by at least one of the second controller C2 or the third controller C3). Hereinafter, the signal output by the first OR circuit 65 will be denoted by StP. When the signal StP has the value of 1, it indicates that the first controller C1 is normal. When the signal StP has the value of 0, it indicates that the first controller C1 malfunctions.

It is not necessary to monitor the status signals St1_2, St1_3 in the first and second AND circuits 61, 63, respectively, if it is simply sought to determine a malfunction of the first controller C1. The reason for monitoring the status signals St1_2, St1_3 in the first and second AND circuits 61, 63, respectively, is to suppress a malfunction that occurs when the second controller C2 malfunctions, placing the status signal St2_1 of the second controller C2 in an indefinite status described later and making it impossible to set the signal StP at the value of 0.

The third AND circuit 66 receives the status signals St3_2 and St2_3. The third AND circuit 66 outputs the value of 0 to the third latch circuit 67 when one of the input status signals St3_2 and St2_3 has the value of 0 (i.e., when the second controller C2 is determined to malfunction by the third controller C3, or the third controller C3 is determined to malfunction by the second controller C2). Meanwhile, the third AND circuit 66 outputs the value of 1 to the third latch circuit 67 when both the input status signals St3_2 and St2_3 have the value of 1 (i.e., when the second controller C2 is not determined to malfunction by the third controller C3, and the third controller C3 is not determined to malfunction by the second controller C2).

The third latch circuit 67 receives the output signal of the third AND circuit 66. The third latch circuit 67 outputs an output signal having the value of 1 to the selection unit 73 when the value of the output signal of the third AND circuit 66 is 1. Meanwhile, the third latch circuit 67 outputs an output signal having the value of 0 to the selection unit 73 and subsequently maintains the output signal of the third latch circuit 67 at a value of 0 when the value of the output signal of the third AND circuit 66 is 0. Hereinafter, the signal output by the third latch circuit 67 will be denoted by StS. When the signal StS has the value of 1, it indicates that the second controller C2 is normal. When the signal StS has the value of 0, it indicates that the second controller C2 malfunctions.

It is not necessary to monitor the status signal St2_3 in the third AND circuit 66 if it is simply sought to determine a malfunction of the second controller C2. The reason for monitoring the status signal St2_3 in the third AND circuit 66 is to suppress a false operation in the case the third controller C3 malfunctions.

The second OR circuit 68 receives the status signals St1_1 and St2_2. The second OR circuit 68 outputs the value of 0 to the fourth AND circuit 71 when both the input status signals St1_1 and St2_2 have the value of 0 (i.e., when an external malfunction is determined to occur by both the first controller C1 and the second controller C2). Meanwhile, the second OR circuit 68 outputs the value of 1 to the fourth AND circuit 71 when at least one of the output signals input thereto has the value of 1 (i.e., when no external malfunction is determined to occur by at least one of the first controller C1 or the second controller C2).

The third OR circuit 69 receives the status signals St1_1 and St3_3. The third OR circuit 69 outputs the value of 0 to the fourth AND circuit 71 when both the input status signals St1_1 and St3_3 have the value of 0 (i.e., when an external malfunction is determined to occur by both the first controller C1 and the third controller C3). Meanwhile, the third OR circuit 69 outputs the value of 1 to the fourth AND circuit 71 when at least one of the input output signals has the value of 1 (i.e., when no external malfunction is determined to occur by at least one of the first controller C1 or the third controller C3).

The fourth OR circuit 70 receives the status signals St2_2 and St3_3. The fourth OR circuit 70 outputs the value of 0 to the fourth AND circuit 71 when both the input status signals St2_2 and St3_3 have the value of 0 (i.e., when an external malfunction is determined to occur by both the second controller C2 and the third controller C3). Meanwhile, the fourth OR circuit 70 outputs the value of 1 to the fourth AND circuit 71 when at least one of the output signals input thereto has the value of 1 (i.e., when no external malfunction is determined to occur by at least one of the second controller C2 or the third controller C3).

The fourth AND circuit 71 receives the output signals of the second-fourth OR circuits 68-70. The fourth AND circuit 71 outputs the value of 0 to the selection unit 73 when at least one of the input signals has the value of 0 (i.e., when an external malfunction is determined to occur by at least two of the first-third controllers C1-C3). Meanwhile, the fourth AND circuit 71 outputs the value of 1 to the selection unit 73 when all the input signals have the value of 1 (i.e., when an external malfunction is determined to occur by one of the first-third controllers C1-C3, or when no external malfunction is determined to occur by all of the first-third controllers C1-C3). Hereinafter, the signal output by the fourth AND circuit will be denoted by StC.

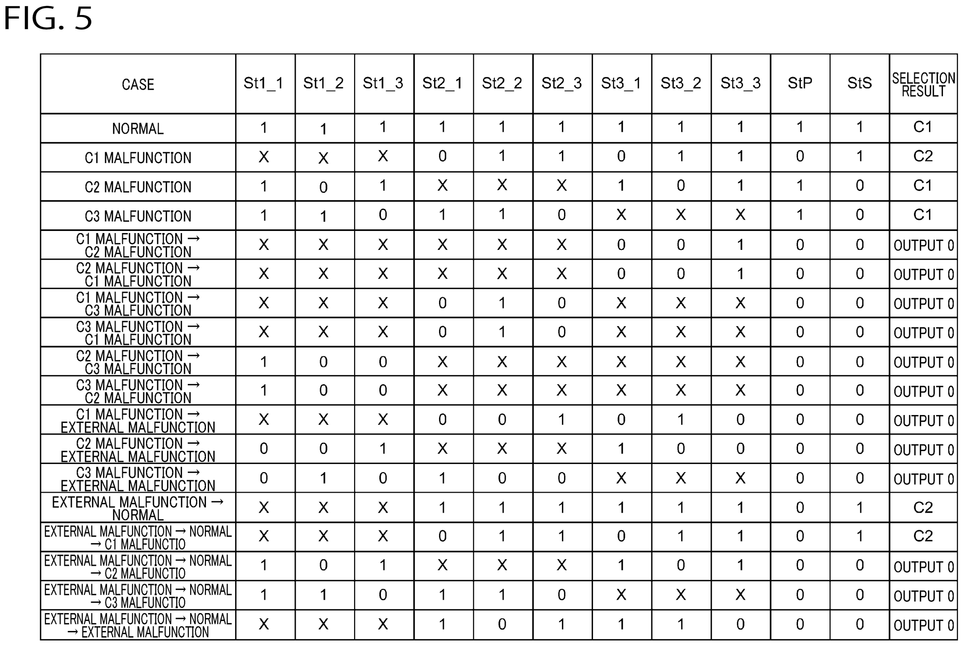

The selection unit 73 receives the signals StP, StS, StC output from the first OR circuit 65, the third latch circuit 67, and the fourth AND circuit 71, the voltage command values Vα1, Vβ1 output from the first controller C1, and the voltage command values Vα2, Vβ2 output from the second controller C2. The selection unit 73 selects the voltage command value to be used from the voltage command values Vα1, Vβ1, the voltage command values Vα2, Vβ2, and the value of 0, based on each signal output from the first OR circuit 65, the third latch circuit 67, and the fourth AND circuit 71 and a predetermined priority order. The selection unit 73 outputs the selected voltage command values to the inverse Clarke transform unit 74 as the voltage command values Vα, Vβ. In the embodiment, the first priority is set in the first controller C1, the second priority is set in the second controller C2, and the third priority is set in the value of 0. Of the first-third priority, the first priority is the highest priority, the second priority is the second highest priority, and the third priority is the lowest priority. Therefore, when both the first controller C1 and the second controller C2 are normal, for example, the voltage command values Vα1, Vβ1 generated from the output signal of the first controller C1 are preferentially selected by the selection unit 73 as the voltage directive values Vα, Vβ based on the priority order. Further, when the first controller C1 malfunctions, for example, the voltage command values Vα2, Vβ2 generated from the output signal of the second controller C2 are preferentially selected as the voltage command values Vα, Vβ by the selection unit 73 based on the priority order. Further, when both the first controller C1 and the second controller C2 malfunction, for example, the value of 0 is selected as the voltage command values Vα, Vβ by the selection unit 73 based on the priority order. Further, the digital voltage signal output by the third controller C3 is not selected by the selection unit 73 since a priority is not set in the third controller C3 (in the embodiment, the digital voltage signal output by the third controller C3 is not input to the signal control unit 211 in the first place). The method of signal selection by selection unit 73 will be described later by using Fig. 5.

The inverse Clarke transform unit 74 generates a three-phase digital voltage signal including a U-phase voltage target value VU, a V-phase voltage target value VV, and a W-phase voltage target value VW by subjecting the two-phase voltage command values Vα, Vβ in the fixed coordinate system output from the selection unit 73 to inverse Clarke transform. The inverse Clarke transform unit 74 outputs the three-phase digital voltage signal to the PWM output unit 75.

The PWM output unit 75 receives, from the inverse Clarke transform unit 74, the three-phase digital voltage signal including the U-phase voltage target value VU, the V-phase voltage target value VV, and the W-phase voltage target value VW. The PWM output unit 212 generates and outputs PWM signals Up, Ud, Vp, Vd, Wp, Wp, Wd for driving respective switching elements (not shown) of a three-phase bridge circuit, based on the U-phase voltage target value VU, the V-phase voltage target value VV, the W-phase voltage target value VW, and, for example, a carrier (carrier wave) that is a triangular wave carrier.

Fig. 5 shows the status of the multiplexing control apparatus 210 for each case. When all controllers C are in the normal status (case in Fig. 5: "normal"), for example, the status signals St all have the value of 1 indicating normal, and the signals StP, StS will have the value of 1. As a result, the selection unit 73 selects the voltage command values Vα1, Vβ1 generated from the output signal of the first controller C1 in which the first priority is set based on the priority order.

For example, a description will be given of a case where the first-third controllers C1-C3 are in the normal status and then the first controller C1 malfunctions (case in Fig. 5: "C1 malfunction"). Since the first controller C1 malfunctions, the status signals St1_1-St1_3 output from the first controller C1 are indefinite and can be 0 or 1. In Fig. 5, indefiniteness of the status signals St1_1-St1_3 is indicated by "X". In the case of "C1 malfunction", the voltage command value output from the first controller C1 will be significantly different from the voltage command value output from the second and third controllers C2 and C3, respectively, and the status signals St2_1 and St3_1 will have the value of 0. As a result, the value of 0 is output from the first and second AND circuits 61, 63, and the signal StP with the value of 0 is output from the first OR circuit 65. Meanwhile, both the second and third controllers C2 and C3 are normal so that the signal StS with the value of 1 is output from the third AND circuit 66. Therefore, the selection unit 73 selects the voltage command values Vα2, Vβ2 generated from the output signal of the second controller C2 in which the second priority is set, based on the priority order.

For example, a description will be given of a case where the first-third controllers C1-C3 are in the normal status and then at least one of the second controller C2 or the third controller C3 malfunctions (case in Fig. 5: "C2 malfunction" and "C3 malfunction"). In this case, the signal StP has the value of 1, while the signal StS has the value of 0. Therefore, the selection unit 73 selects the voltage command values Vα1, Vβ1 generated from the output signal of the first controller C1 based on the priority order.

For example, a description will be given of a case where the second controller C2 malfunctions after the first controller C1 malfunctions (case in Fig. 5: "C1 malfunction ->C2 malfunction"). In this case, not only the status signals St1_1-St1_3 output from the first controller C1 but also the status signals St2_1-St2_3 output from the second controller C2 will also be indefinite. In this case, the output signals of the first and second latch circuits 62 and 64 are maintained at the value of 0 so that the signal StP with the value of 0 is output from the first OR circuit 65. Meanwhile, the second controller C2 malfunctions so that the signal StS with the value of 0 is output from the third AND circuit 66. Therefore, the selection unit 73 selects and outputs the signal with the value of 0 in which the third priority is set, based on the priority order ("Output 0" in the selection result field in Fig. 5). When the selection unit 73 outputs the signal with the value of 0, the motor 300 stops.

For example, the selection unit 73 outputs the signal with the value of 0, and the motor 300 stops when an external malfunction occurs after the first controller C1 malfunctions (case in Fig. 5 "C1 malfunction->external malfunction"), when an external malfunction occurs after the second controller C2 malfunctions (case in Fig. 5 "C2 malfunction->external malfunction"), and when an external malfunction occurs after the third controller C3 malfunctions (case in Fig. 5 "C3 malfunction->external malfunction").

When an external malfunction occurs and then the normal status is resumed (case in Fig. 5 "external malfunction->"normal"), for example, the first controller C1 may have been the cause of the external malfunction. Therefore, the status signals St1_1-St1_3 output from the first controller C1 will be indefinite, and the signal StP with the value of 0 is output from the first OR circuit 65. Meanwhile, both the second and third controllers C2 and C3 are normal so that the signal StS with the value of 1 is output from the third AND circuit 66. Therefore, the selection unit 73 selects the voltage command values Vα2, Vβ2 generated from the output signal of the second controller C2 in which the second priority is set, based on the priority order. Thereafter, the voltage command values Vα2 and Vβ2 generated from the output signal of the second controller C2 are selected even after the normal status is resumed. When an external malfunction occurs and then the normal status is resumed and, subsequently, the first controller C1 malfunctions (case in Fig. 5 "external malfunction->normal->C1 malfunction"), the voltage command values Vα2, Vβ2 generated from the output signal of the second controller C2 are similarly selected. The selection unit 73 outputs the signal with the value of 0, and the motor 300 stops when an external malfunction occurs and then the normal status is resumed and, subsequently, the second controller C2 malfunctions (case in Fig. 5 "external malfunction->normal->C2 malfunction), when an external malfunction occurs and then the normal status is resumed and, subsequently, the third controller C3 malfunctions (case in Fig. 5 "external malfunction->normal->C3 malfunction), and when an external malfunction occurs and then the normal status is resumed and, subsequently, an external malfunction occurs (case in Fig. 5 "external malfunction->normal->external malfunction).

The embodiment shows an example of applying the multiplexing control apparatus 210 to the motor 300 of eVTOL1, but the embodiment is not limited to this. The multiplexing control apparatus 210 of the embodiment is applicable to various motors.

In the embodiment, the digital voltage signal output from the third controller C3 is not input to the signal control unit 211, but the embodiment is not limited to this. The digital voltage signal output from the third controller C3 may be input to the signal control unit 211. In this case, the output signal of one of the three controllers C1-C3 may be selected.

Further, the multiplexing control apparatus 210 may include: two controllers C, wherein a given controller C outputs a result of evaluation of a health of a further controller C to the signal control unit 211 in the form of a status signal St, the health being evaluated based on a comparison between two-phase voltage command values generated by the given controller C and two-phase voltage command values generated by the further controller. The multiplexing control apparatus 210 may further include an internal logic (e.g., CPLD) of the signal control unit 211 that transfers, when the given controller C malfunctions, control to the further controller C and that suspends control in the presence of an output difference between the further controller C that is normal and the given controller C. This can reduce the number of components used in a multiple redundancy circuit, making it possible to perform redundant PWM control in a simplified circuit. Further, each output line is subject to switching according to digital processing described above so that redundant motor PWM control with fewer transients (temporary changes) can be performed.

In the embodiment, an example where three controllers C1-C3 are provided is shown, but the embodiment is not limited to this, and two or more (multiple) controllers may be provided.

To summarize the above, the multiplexing control apparatus 210 of the embodiment includes: three controllers C1-C3 that output a digital voltage signal including two-phase voltage command values for the motor 300 in an orthogonal coordinate (fixed-coordinate) system (α, β); and a signal control unit 211 that receives the digital voltage signal output from at least two of the three controllers C1-C3, selects, based on a predetermined priority order, the digital voltage signal output by the controller C, of the controllers C outputting the digital signal input to the signal control unit 211, that does not malfunction and generates and outputs a PWM signal based on the digital voltage signal selected. According to this configuration, it is possible to perform multiplexing control through digital signal processing. As a result, the resolution can be improved while also making control less susceptible to PWM noise. Further, each controller C does not need to generate a PWM signal so that the circuit size of the controller C can be reduced, and the device configuration can be simplified and lightweight as a result.

In the multiplexing control apparatus 210 of the embodiment, each given controller C includes: the first status monitoring unit 58 that outputs, based on a comparison between two-phase voltage command values generated by the given controller C and two-phase voltage command values of a further controller C, a first status signal indicating whether the further controller malfunctions; the second status monitoring unit 59 that outputs, based on a comparison between the two-phase voltage command values generated by the given controller C and two-phase voltage command values of a still further controller C, a second status signal indicating whether the still further controller malfunctions, wherein the signal control unit 211 identifies the controller C that does not malfunction, based on the first status signal and the second status signal output from the controllers C. According to this configuration, it is possible to accurately determine whether each controller C malfunctions through digital signal processing. Further, it is possible to reduce the computational load by determining whether each controller C malfunctions by using two-phase voltage command values in the orthogonal coordinate system.

In the multiplexing control apparatus 210, the three controllers C are the first controller C1, the second controller C2, and the third controller C3, the signal control unit 211 receives the digital voltage signal from the first controller C1 and the second controller C2, and the signal control unit 211 includes: the malfunction determination unit 72 that determines whether the first controller C1 malfunctions based on the first status signal output from the second controller C2 and the third controller C3 and determines whether the second controller malfunctions based on the second status signal output from the third controller; the selection unit 73 that selects and outputs the voltage command value in the digital voltage signal output by the controller C, of the first controller and the second controller, that does not malfunction; the inverse Clarke transform unit 74 that outputs a three-phase digital voltage signal of the U phase, the V phase and the W phase by subjecting the voltage command value output from the selection unit 73 to inverse Clarke transform; and the PWM output unit 75 that outputs a PWM signal based on the three-phase digital voltage signal output from the inverse Clarke transform unit 74. According to this configuration, it is possible to properly select the digital voltage signal of the controller C, of the first controller C1 and the second controller C2, that does not malfunction and output the PWM signal.

In the multiplexing control apparatus 210 of the embodiment, the selection unit 73 selects and outputs the value of 0 as the voltage command value when both the first controller C1 and the second controller C2 malfunction. According to this configuration, the motor 300 can be inhibited from running out of control when both the first controller C1 and the second controller C2 malfunction.

Described above is an explanation based on the embodiment. The embodiment is intended to be illustrative only and it will be understood by those skilled in the art that various modifications to combinations of constituting elements and processes are possible and that such modifications are also within the scope of the present invention.

The function and the configuration of each apparatus explained in the embodiment can be realized by hardware resources or software resources or cooperation between hardware resources and software resources. As the hardware resources, processors, ROMs, RAMs, CPLD, or other LSIs can be employed. Programs such as operating systems and applications can be used as software resources.

Of the embodiments disclosed in this specification, those in which a plurality of functions are provided in a distributed manner may be provided by aggregating some or all of the plurality of functions. Conversely, a plurality of functions provided in an aggregated manner may be provided by distributing some of all of the plurality of functions. Regardless of whether functions are aggregated or distributed, they may be configured so as to achieve the purpose of the invention.

## Claims

1. A multiplexing control apparatus (210) comprising:
three controllers (C1, C2, C3) that output a digital voltage signal including two-phase voltage command values for a motor (300) in an orthogonal coordinate system; and
a signal control unit (211) that receives the digital voltage signal output from at least two of the three controllers (C1, C2, C3), selects, based on a predetermined priority order, the digital voltage signal output by the controller (C), of the controllers (C) outputting the digital signal input to the signal control unit (211), that does not malfunction and generates and outputs a PWM signal based on the digital voltage signal selected.

2. The multiplexing control apparatus (210) according to claim 1,
each given controller (C1, C2, C3) includes:
a first status monitoring unit (58) that outputs, based on a comparison between two-phase voltage command values generated by the given controller (C) and two-phase voltage command values of a further controller (C), a first status signal indicating whether the further controller (C) malfunctions;
a second status monitoring unit (59) that outputs, based on a comparison between the two-phase voltage command values generated by the given controller (C) and two-phase voltage command values of a still further controller (C), a second status signal indicating whether the still further controller (C) malfunctions,
wherein the signal control unit (211) selects the voltage command value output by the controller (C) that does not malfunction, based on the first status signal and the second status signal output from the controllers (C).

3. The multiplexing control apparatus (210) according to claim 2,
wherein the three controllers (C1, C2, C3) are a first controller (C1), a second controller (C2), and a third controller (C3),
wherein the signal control unit (211) receives the digital voltage signal from the first controller (C1) and the second controller (C2),
wherein the signal control unit (211) includes:
a malfunction determination unit (72) that determines whether the first controller (C1) malfunctions based on the first status signal output from the second controller (C2) and the third controller (C3) and determines whether the second controller (C2) malfunctions based on the second status signal output from the first controller (C1) and the third controller (C3);
a selection unit (73) that selects and outputs the voltage command value in the digital voltage signal output by the controller (C), of the first controller (C1) and the second controller (C2), that does not malfunction;
an inverse Clarke transform unit (74) that outputs a three-phase digital voltage signal of a U phase, a V phase and a W phase by subjecting the voltage command value output from the selection unit (73) to inverse Clarke transform; and
a PWM output unit (75) that outputs the PWM signal based on the three-phase digital voltage signal output from the inverse Clarke transform unit (74).

4. The multiplexing control apparatus (210) according to claim 3,
wherein the selection unit (73) selects and outputs a value of 0 as the voltage command value when both the first controller (C1) and the second controller (C2) malfunction.
